# EUROPEAN PATENT SPECIFICATION

(11) **EP 2 948 781 B1**
(45) Date of publication and mention of the grant of the patent: **21.06.2017**
(21) Application number: 13829015.0
(22) Date of filing: 31.12.2013
(51) Int. Cl.: G01R 23/17, G02F 1/33, H01S 3/106, H01S 3/00

(54) **RF SIGNAL DETECTION SYSTEM**
HF-SIGNAL-DETEKTIONSSYSTEM
SYSTÈME DE DÉTECTION DE SIGNAUX RF

(30) Priority: 27.01.2013 PL 40256613
(43) Date of publication of application: 02.12.2015
(73) Proprietor: Instytut Optyki Stosowanej, 03-805 Warszawa (PL)
(72) Inventor: GALAS, Jacek, PL-05-092 Lomianki (PL); CZYZEWSKI, Adam, PL-00-132 Warszawa (PL); LITWIN, Dariusz, PL-00-681 Warszawa (PL)
(86) International application number: PCT/PL2013/000178
(87) International publication number: WO 2014/116129

(56) References cited:
- WO-A1-00/13839
- WO-A1-01/63351
- WO-A1-91/06014
- US-A- 4 297 704
- US-A- 4 467 276
- US-A- 4 503 388
- US-B1- 6 307 895
- DATABASE WPI Week 198951 Thomson Scientific, London, GB; AN 1989-373041 XP002723767, -& JP H01 277767 A (HAMAMATSU PHOTONICS KK) 8 November 1989 (1989-11-08)

## Description

The subject of the invention is a system for detecting RF signals, intended for detecting and measuring electromagnetic signals transmitted in radio frequency bands ranging from 3 kHz to 300 GHz, for use in telecommunications, military and civilian applications.

The description of US4503388 patent shows a system for detecting RF (radio frequency) signals using the diffraction of a coherent light beam on a diffraction grating generated in an acousto-optic component as a result of acoustic wave propagating inside it. The wave is excited by a piezoelectric transducer connected to the antenna. The acousto-optic component diffracts a light beam proportionally to the RF signal frequency. Behind the acousto-optic unit there is a focusing lens, semiconductor amplifier and a linear photodetector. The detection system for RF signals includes a monochromatic laser emitting a beam of light at a specific wavelength, depending on the type of active medium. In a typical embodiment, this is a laser arranged as a resonator system, comprising an active medium pumping system placed in a resonant cavity between the system of parallel mirrors, one of which constitutes a semi-reflective outlet mirror. Pumping the active medium results in population inversion that leads to stimulated photon emission. The mirrors reflect part of the emitted photons back to the active medium. Such an optical system is a type of resonator for a specific frequency of electromagnetic waves.

A disadvantage of such RF detection systems is their limited scope of application and the necessity of using complex laser light amplifiers.

The description of WO9106014 discloses a broadband electrical signal spectrum analyser which comprises a spatial light modulator such as a Bragg cell located within at least one resonant cavity and illuminated by a polychromatic source of light. The analyzer is equipped with an acousto-optic component diffracting a light beam emitted by a monochromatic laser resonator system, and focusing lens placed in the path of diffracted light beam between the acousto-optic component and a multi-segment photo detector.

Further relevant analysers having the features mentioned in preamble of claim 1 are presented in US6307895 and US4467276.

The system for RF signal detection, equipped with an acousto-optic component that diffracts the light beam emitted in a monochromatic laser resonator system, a focusing lens placed in the route of diffracted light beam placed between the acousto-optic unit and a multi-segment photo detector, while the acousto-optic unit includes a piezoelectric transducer connected to an antenna, according to the invention, rely on that its acousto-optic component is placed together with a focusing lens in the monochromatic laser resonator system between an active medium and an matrix of optical fibers, which create a semi-reflective output mirror integrated with a multi-segment photo-detector, while the endfaces of optical fibers are located perpendicularly to the light beam and covered with a semi-reflective layer, and the opposite ends of the optical fibers are connected to the multi-segment detector.

Advantageously, if the endfaces of optical fibers constituting the matrix form a concave spherical mirror directed towards the focusing lens. In particular, the endfaces of optical fibers creating the concave spherical mirror are located in a single plane perpendicular to their surface.

Advantageously, if the focusing lens surface is coated with an anti-reflection layer.

Advantageously also, if each optical fiber in optical fiber matrix is connected to different photosensitive unit of the multi-segment photo detector.

In the solution proposed by the invention, the acousto-optic component is a part of the monochromatic laser resonator system, changing the direction of beam propagation inside the resonant cavity, while the matrix of optical fibers is formed in such a way that each optical fiber can operate as a fragment of the resonator output mirror, depending on the angle of diffraction induced by the acousto-optic component. In this resonator arrangement only the light projected perpendicularly to the optical fiber is amplified. This light is recorded on the multi-segment photodetector. Thanks to the selective amplification of signal propagating at a specific direction, i.e. for a specific angle of light beam diffraction, it is possible to record even very weak signals. Based on the signal distribution, it is possible to determine the angle of beam diffraction, and consequently, the RF signal parameters within the whole range of electromagnetic waves at a very high signal-to-noise ratio.

The invention is presented in one of the embodiments in a figure that shows a schematic diagram of the RF signal detection system.

The RF signal detection system is equipped with an acousto-optic component 4 placed together with the focusing lens 7 in the monochromatic laser resonator system between active medium 1, and the matrix of optical fibers 5 that constitute the semi-reflective output mirror integrated with the multi-segment photodetector 6. The acousto-optic component 4 consists of a piezoelectric transducer connected to an RF receiving antenna. The acousto-optic unit 4 diffracts a light beam emitted in the resonator towards the focusing lens 7, and it focuses the passing light beam on a fragment of the matrix of optical fibers 5. The endfaces of optical fibers 5 are situated perpendicularly to the direction of light beam and covered partly with a light reflecting layer, while the opposite ends of optical fibers 5 are connected to the multi-segment photo detector 6. The multi-segment photo detector 6 can be made in the shape of a photo ruler, matrix or other set of photosensitive components. The endfaces of optical fibers 5 being part of optical fibers 5 matrix have the form of a spherical concave mirror directed to the focusing lens 7. Such a mirror can be made with one row of optical fibers 5 with their endfaces situated in a single plane perpendicular to their surface. It can be a spherical mirror made in spatial or planar technology. For planar technology mirror, optical fibers 5 will be made as specially designed planar optical fibers. The surface of focusing lens 7 should be coated with an anti- reflective layer to avoid initialization of laser action on this particular system component.

The monochromatic laser resonator system includes a pumping system 2 for active medium 1 and a reflecting mirror 3 of the reflection coefficient equals to 100%. The pumping system 2 can use diode illuminants or flashlights to provide light for active medium 1 in the form of a crystal, which results in exciting the active medium 1 and obtaining population inversion. As a result of spontaneous emission, photons from active medium 1 are emitted at all directions. Part of them is projected onto the acousto-optic system 4, where RF signals are transformed into acoustic signals. The acoustic signals stimulate the generation of spatial diffraction grating by the periodic condensing and dissolving the acousto-optic component 4. The photons emitted spontaneously from active medium 1 falling onto the generated diffraction grating are subject to diffraction. The angle of light beam diffraction, for a specific wavelength depends on the diffraction grating period. A diffracted light beam is partly reflected from the optical fibers 5 matrix. The layer, the optical fibers 5 endfaces are covered with, should reflect approximately 60% of the incoming light. The light reflected from optical fiber 5, whose endface is perpendicular to the direction of incoming beam, returns to the resonator system starting the process of laser light emitting in the active medium 1. It results in a considerable amplification of light beam emitted in the specific direction defined by its diffraction angle on the diffraction grating. The focusing lens 7 set in the path of diffracted light beam is intended for focusing light on optical fibers 5, thus increasing the resolution of the system in terms of frequency. Part of the light passing through the optical fibers 5 reaches the multi-segment photo detector 6 fitted with photosensitive components measuring the intensity of light propagating within each optical fiber 5. By comparing signals with particular photo components it is possible to determine the angle of beam diffraction on the diffraction grating, thus, knowing the laser wavelength it is possible to determine the parameters of an RF signal incoming to the acousto-optic system 4.

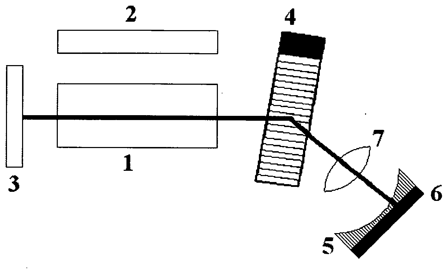

## Claims

1. An RF signal detection system, equipped with an acousto-optic component diffracting a light beam emitted in a monochromatic laser resonator system, focusing lens placed in the path of diffracted light beam between the acousto-optic component and a multi-segment photo detector, while the acousto-optic component includes a piezoelectric transducer connected to an antenna, **characterized in that** the acousto-optic component (4) is placed together with a focusing lens (7) in the monochromatic laser resonator system between an active medium (1) and an optical fibers (5) matrix, where the optical fibers (5) create a partly- reflective output mirror integrated with the multi-segment photo-detector (6), while the endfaces of the optical fibers (5) are located perpendicularly to the light beam and covered with a partly-reflecting layer, and the opposite ends of the optical fibers (5) are connected to the multi-segment detector (6).

2. The system according to claim 1, wherein the endfaces of optical fibers (5) form the shape of a spherical concave mirror directed towards the focusing lens (7).

3. The system according to claim 2, wherein the endfaces of optical fibers (5) forming the shape of spherical concave mirror are situated in a single plane perpendicular to their surface.

4. The system according to claim 1, wherein the surface of focusing lens (7) is coated with an anti-reflective layer.

5. The system according to claim 1, wherein each optical fiber (5) in the matrix of optical fibers (5) is connected to different photosensitive component of the multi-segment photo detector (6).

## Patentansprüche

1. HF-Signal-Detektionssystem, enthaltend ein akustisch-optisches Element, das ein im System des Resonators eines monochromatischen Lasers ausgestrahltes Strahlenbündel beugt, eine auf dem Weg des gebeugten Strahlenbündels zwischen dem akustischoptischem Element und einem multisegmentalen Photodetektor angebrachte Sammellinse, wobei das akustisch-optisches Element einen mit einer Antenne verbundenen piezoelektrischen Sensor enthält, **gekennzeichnet dadurch, dass** sich das akustisch-optisches Element (4) zusammen mit der Sammellinse (7) im System des Resonators zwischen dem laseraktiven Medium (1) und der Lichtleitfasermatrix (5) befindet, wobei die Lichtleitfasern (5) einen teilweise durchlässigen, mit dem multisegmentalen Photodetektor (6) integrierten Auskoppelspiegel bilden, wobei sich die Eingangspalten der Lichtleitfasern (5) senkrecht zum einfallenden Strahlenbündel befinden und mit einem teilweise reflektierenden Schicht bedeckt sind, und die entgegengesetzten Enden der Lichtleitfasern (5) an den multisegmentalen Detektor (6) angeschlossen sind.

2. System nach Anspruch 1, **gekennzeichnet dadurch, dass** die Eingangspalten der Lichtleitfasern (5) zu einem hohlen, auf die Sammellinse (7) gerichteten Kugelspiegel geformt sind.

3. System nach Anspruch 2, **gekennzeichnet dadurch, dass** die Eingangspalten der Lichtleitfasern (5), zu einem hohlen Kugelspiegel geformt, in einer senkrecht zu ihrer Fläche gelegenen Ebene angebracht sind.

4. System nach Anspruch 1, **gekennzeichnet dadurch, dass** die Fläche der Sammellinse (7) mit einem Antireflexschicht bedeckt ist.

5. System nach Anspruch 1, **gekennzeichnet dadurch, dass** jedes Lichtleitfaser (5) in der Lichtleitfasermatrix (5) an ein anderes lichtempfindliches Element des multisegmentalen Photodetektors (6) angeschlossen ist.

## Revendications

1. Le système de détection de signaux RF est équipé d'un élément acoustique - optique pliant le faisceau de lumière émis dans le système du résonateur du laser monochromatique, d'une lentille convergente placée sur la route du faisceau plié de lumière entre l'élément acoustique - optique et le photodétecteur multisegmentaire, où le transducteur piézoélectrique lié à l'antenne fait partie de l'élément acoustique - optique, **caractérisé en ce que** l'élément acoustique - optique (4) est placé avec la lentille convergente (7) dans le système du résonateur entre le centre actif (1) et la matrice des fibres optiques (5); et ces fibres optiques (5) forment le miroir de sortie, en partie perméable, intégré au photodétecteur multisegmentaire (6), où les faces des fibres optiques (5) sont placées perpendiculairement à la direction du faisceau de lumière incident et revêtues d'une couche qui, en partie, réfléchit la lumière, alors que les bouts opposés des fibres optiques (5) sont liés au détecteur multisegmentaire (6) .

2. Le système selon la revendication 1, **caractérisé en ce que** les faces des fibres optiques (5) sont en forme du miroir sphérique concave dirigé vers la lentille convergente (7).

3. Le système selon la revendication 2, **caractérisé en ce que** les faces des fibres optiques (5) en forme du miroir spérique concave sont placées sur une surface perpendiculaire à leur surface.

4. Le système selon la revendication 1, **caractérisé en ce que** la surface de la lentille convergente (7) est revétue d'une couche antireflet.

5. Le système selon la revendication 1, **caractérisé en ce que** chaque fibre optique (5) dans la matrice des fibres optiques (5) est branchée à un autre élément photosensible du photodétecteur multisegmentaire (6).
